# EUROPEAN PATENT SPECIFICATION

(11) **EP 1 928 085 B1**
(45) Date of publication and mention of the grant of the patent: **17.02.2010**
(21) Application number: 07012716.2
(22) Date of filing: 28.06.2007
(51) Int. Cl.: H03D 3/00

(54) **Method and system for multimode DC offset compensation**
Verfahren und System zum multimodalen Ausgleich von DC-Offsets
Procédé et dispositif pour compenser un décalage continu

(30) Priority: 30.11.2006 US 565562
(43) Date of publication of application: 04.06.2008
(73) Proprietor: Broadcom Corporation, Irvine, CA 92617 (US)
(72) Inventor: Li, Junqiang, Irvine CA 92617 (US); Sollenberger, Nelson, Irvine CA 92617 (US); Chang, Li Fung, Irvine CA 92617 (US)
(74) Representative: Jehle, Volker Armin

(56) References cited:
- US-A- 4 888 557
- US-A- 5 881 376
- US-A1- 2003 203 728
- US-A1- 2005 009 493
- US-B1- 6 535 560

## Description

### FIELD OF THE INVENTION

Certain embodiments of the invention relate to wireless communication. More specifically, certain embodiments of the invention relate to a method and system for multimode DC offset compensation.

### BACKGROUND OF THE INVENTION

In some conventional systems, a radio frequency (RF) signal may be converted to an intermediate frequency (IF), and then from IF to a baseband signal, where the IF may be in the megahertz range. Generally, the RF signal may be mixed with a local oscillator signal that results in two sideband signals that are the sum of the frequencies of the two signals and the difference of the frequencies of the two signals. One of the two sideband signals may be chosen as an IF signal, and this IF signal may be the same for all received RF signals. Therefore, a radio that may receive a plurality of channels, such as an AM or FM radio, may tune to a particular station by changing the local oscillator signal frequency such that the IF remains constant. With a constant IF, most of the receive path may be common in the receiver. Other radios may convert a received signal directly from RF to a baseband signal to reduce IF circuitry.

The process of retrieving information from an RF signal may be referred to as demodulation. The presence of direct current (DC) offsets is undesirable if data is to be accurately recovered during demodulation. The DC offsets in the demodulated output of, for example, a frequency modulated (FM) system may occur when the local oscillator of a transmitting radio generates a signal with a slightly different frequency than the frequency of the signal produced by the receiving radio local oscillator. The DC offset due to frequency mismatch may adversely affect the data extracted from the IF or baseband signals. The patent US-2003/0203728 discloses a prior art receiver with DC offset compensation.

Further limitations and disadvantages of conventional and traditional approaches will become apparent to one of skill in the art, through comparison of such systems with some aspects of the present invention as set forth in the remainder of the present application with reference to the drawings.

### BRIEF SUMMARY OF THE INVENTION

A method and system for multimode DC offset compensation, substantially as shown in and/or described in connection with at least one of the figures, as set forth more completely in the claims.
According to an aspect of the invention, a method for processing signals in a circuit is provided, the method comprising:
selecting a number of signal samples to use for generation of a feedback signal;
averaging said number of signal samples; and
accumulating said determined average for said feedback signal generation in order to attenuate a signal offset.
Advantageously, said signal samples are samples of WCDMA signals.
Advantageously, said selected number of signal samples is based on a signal offset error.
Advantageously, said selected number of signal samples is one of at least two numbers.
Advantageously, the method further comprises assigning a larger of said at least two numbers when a signal offset error is less than or equal to a threshold.
Advantageously, the method further comprises assigning a smaller of said at least two numbers when a signal offset error is greater than a threshold.
Advantageously, the method further comprises accumulating a total value for said selected number of signal samples for use in said averaging of said selected number of signal samples.
Advantageously, said selected number of signal samples is equal to 2^{N}, wherein N is an integer.
Advantageously, the method further comprises shifting right said total value by said N number of bits for said averaging of said selected number of signal samples.
According to an aspect of the invention, a machine-readable storage is provided having stored thereon, a computer program having at least one code section for processing signals in a circuit, the at least one code section being executable by a machine for causing the machine to perform steps comprising:
selecting a number of signal samples to use for generation of a feedback signal;
averaging said selected number of signal samples; and
accumulating said determined average for said feedback signal generation in order to attenuate a signal offset.
Advantageously, said signal samples are samples of WCDMA signals.
Advantageously, said selected number of signal samples is based on a signal offset error.
Advantageously, said selected number of signal samples is one of at least two numbers.
Advantageously, said at least one code section comprises code for assigning a larger of said at least two numbers when a signal offset error is less than or equal to a threshold.
Advantageously, said at least one code section comprises code for assigning a smaller of said at least two numbers when a signal offset error is greater a threshold.
Advantageously, said at least one code section comprises code for accumulating a total value for said selected number of signal samples for use in said determining said average of said selected number of signal samples.
Advantageously, said selected number of signal samples is equal to 2^{N}, wherein N is an integer.
Advantageously, said at least one code section comprises code for shifting right said total value by said N number of bits for said averaging of said selected number of signal samples.
According to an aspect of the invention, a system for processing signals in a circuit comprises:
at least one circuit that selects a number of signal samples to use for generation of a feedback signal;
said at least one circuit determines an average of said number of signal samples; and
said at least one circuit accumulates said determined average for said feedback signal generation.
Advantageously, said signal samples are samples of WCDMA signals.
Advantageously, said number of signal samples is based on a signal offset error.
Advantageously, said selected number of signal samples is one of at least two numbers.
Advantageously, said at least one circuit assigns a larger of said at least two numbers when a signal offset error is less than or equal to a threshold.
Advantageously, said at least one circuit assigns a smaller of said at least two numbers when a signal offset error is greater than a threshold.
Advantageously, said at least one circuit generates a total value for accumulation of said selected number of signal samples for use in said determining said average of said selected number of signal samples.
Advantageously, said selected number of signal samples is equal to 2^{N}.
Advantageously, said at least one circuit shifts right said total value by said N number of bits to said determine said average of said selected number of signal samples.

These and other advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1A is a block diagram of an exemplary transmitter system and a receiver system that may be utilized in connection with an embodiment of the invention.

FIG. 1B is a block diagram of an exemplary RF receiver system that may be utilized in connection with an embodiment of the invention.

FIG. 2A is a block diagram of an exemplary receive path, which may be utilized in connection with an embodiment of the invention.

FIG. 2B is a diagram illustrating exemplary sampling of a waveform, in accordance with an embodiment of the invention.

FIG. 3 is a block diagram of exemplary DC offset compensation circuitry, in accordance with an embodiment of the invention.

FIG. 4 is a block diagram of an exemplary multi-mode DC offset compensation circuitry, in accordance with an embodiment of the invention.

FIG. 5 is an exemplary flow chart for DC offset compensation, in accordance with an embodiment of the invention.

FIG. 6 is an exemplary flow chart illustrating multi-mode DC offset compensation, in accordance with an embodiment of the invention.

### DETAILED DESCRIPTION OF THE INVENTION

Certain embodiments of the invention relate to a method and system for multimode DC offset compensation. Aspects of the method may comprise accumulating a selected number of signal samples, determining an average of the accumulated signal samples, and keeping a running total of the average for use feedback signal generation. The signal samples may be, for example, samples of a WCDMA signal. By keeping track of the signal offset error, the signal offset error may be determined. For example the signal offset error may comprise a DC component and/or a sinusoidal component. The number of signal samples to accumulate for the average may be based on the signal offset error, which may be a residual DC value.

A threshold frequency may be determined, which may be based on, for example, analysis of receiver characterization. A number of signal samples may be selected to be used when the signal offset error is less than or equal to the threshold. A smaller number of signal samples may be selected and used when the signal offset error is greater than the threshold. The accumulated number of signal samples may be divided by the number of signal samples to determine an average signal offset error of the accumulated signal samples. An embodiment of the invention may utilize the number of signal samples to be, for example, 2^{N}. Accordingly, dividing by 2^{N} may comprise right shifting the value to be divided by N bits.

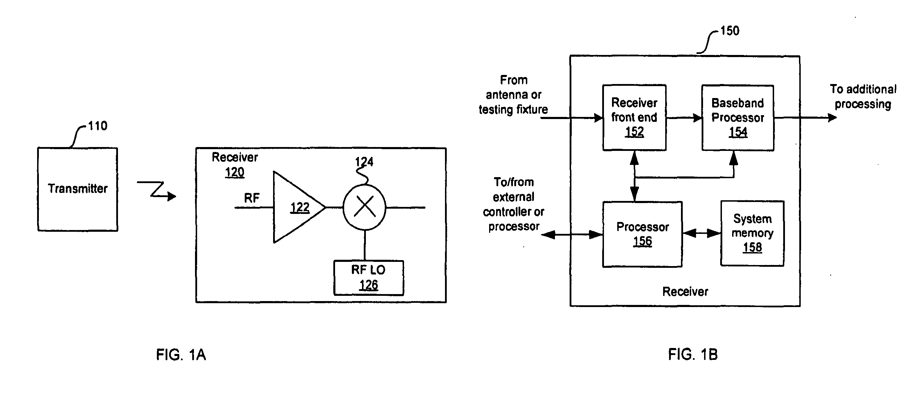

FIG. 1A is a block diagram of an exemplary transmitter system and a receiver system. Referring to FIG. 1A, there is shown a transmitter block 110 and a receiver block 120. The transmitter block 110 may comprise suitable logic, circuitry, and/or code that may be adapted to filter and modulate a baseband signal to an RF signal, and transmit the RF signal. The receiver block 120 may comprise suitable logic, circuitry, and/or code that may be adapted to demodulate the RF signal to the baseband signal. For example, the receiver block 120 may comprise a low noise amplifier 122, a mixer 124 and a local oscillator 126.

In operation, the transmission block 110 may be adapted to transmit RF signals over a wired or wireless medium. The receiver block 120 may be adapted to receive the RF signals and process it to a baseband signal that may be suitable for further processing, for example, as data or voice. For example, the low noise amplifier 122 may amplify the received RF signal, and the mixer 124 may mix the amplified RF signal with a signal from the local oscillator 126. The output of the mixer 124 may be a signal that is at a lower frequency than the received RF frequency. For example, the output of the mixer may be a baseband signal. In some instances, when the signal from the local oscillator 126 does not match the frequency of the RF carrier of the received RF frequency, the mixer 124 may introduce a bias signal. The bias signal may be a DC offset, or the bias signal may be a sinusoidal signal. It may be desirable to attenuate the bias signal.

FIG. 1B is a block diagram of an exemplary RF receiver system, in accordance with an embodiment of the invention. Referring to FIG. 1B, the RF receiver system 150 may comprise a receiver front end 152, a baseband processor 154, a processor 156, and a system memory 158. The receiver front end 152 may comprise suitable logic, circuitry, and/or code that may be adapted to receive an RF signal. The receiver front end 152 may be coupled to an external antenna for signal reception. The receiver front end 152 may demodulate a received signal before further processing. Moreover, the receiver front end 152 may comprise other functions, for example, filtering the received signal, amplifying the received signal, and/or downconverting the received signal to very low intermediate frequency (VLIF) signal and/or baseband signal. The receiver front end 152 may comprise a IF processor which may digitize an IF signal, and digitally process the digitized IF signal to filter and/or downconvert the digitized IF signal to a digital baseband signal. The IF processor may then convert the digitized baseband signal to an analog baseband signal.

The baseband processor 154 may comprise suitable logic, circuitry, and/or code that may be adapted to process analog baseband signals generated from the receiver front end (RFE) 152. The processor 156 may comprise suitable logic, circuitry, and/or code that may be adapted to control the operations of the receiver front end 152 and/or the baseband processor 154. For example, the processor 156 may be utilized to update and/or modify programmable parameters and/or values in a plurality of components, devices, and/or processing elements in the receiver front end 152 and/or the baseband processor 154. Control and/or data information may be transferred from a processor external to the RF receiver system 150 to the processor 156. Similarly, the processor 156 may transfer control and/or data information to at least one controller and/or processor external to the RF receiver system 150.

The processor 156 may utilize the received control and/or data information to determine the mode of operation of the RFE 152. For example, the processor 156 may select a specific frequency for a local oscillator, or a specific gain for a variable gain amplifier. Moreover, the specific frequency selected and/or parameters needed to calculate the specific frequency, and/or the specific gain value and/or the parameters needed to calculate the specific gain, may be stored in the system memory 158 via the processor 156. This information stored in system memory 158 may be transferred to the RFE 152 from the system memory 158 via the processor 156. The system memory 158 may comprise suitable logic, circuitry, and/or code that may be adapted to store a plurality of control and/or data information, including parameters needed to calculate frequencies and/or gain, and/or the frequency value and/or gain value.

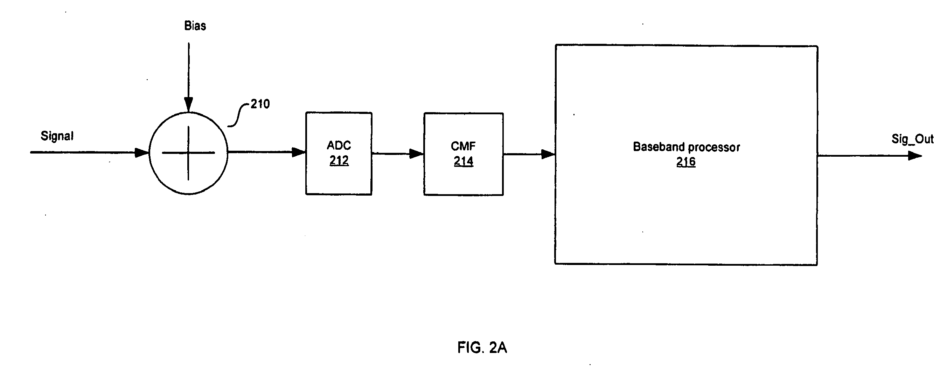

FIG. 2A is a block diagram of an exemplary receive path, in accordance with an embodiment of the invention. Referring to FIG. 2A, there is shown a combiner 210, an analog to digital converter (ADC) 212, a chip matched filter (CMF) block 214, and a baseband processor 216. The combiner 210 may be a logical representation of circuitry used in a RF receiver that may introduce DC offset to a received signal. For example, the offset signal Bias to the combiner 210 may be the DC offset introduced to a baseband signal of the received RF signal by the receiver front end 152.

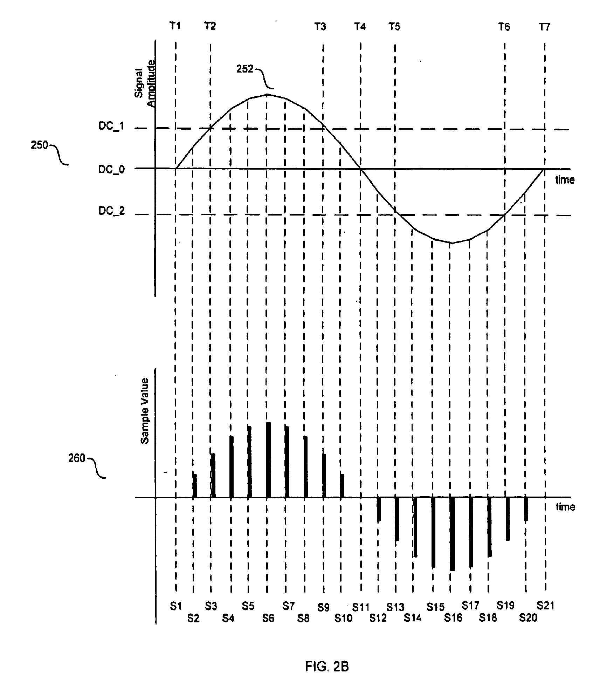

The ADC 212 may comprise suitable logic, circuitry, and/or code that may enable conversion of analog signals to equivalent digital signals. The CMF block 214 may comprise suitable logic, circuitry and/or code that may be adapted to filter a digital baseband signal. The CMF block 214 may be used, for example, for receiving for WCDMA signal. The CMF block 214 may comprise a plurality of digital filters, which may be utilized to filter an in-phase (I) component and a quadrature (Q) component of the digital baseband signal. The digital filters may have a combined impulse response that may be, for example, square root raised cosine (SRRC), which may be required by, for example, the WCDMA specifications. A diagram illustrating exemplary sampling is described with respect to FIG. 2B.

In operation, the received signal may be processed by the receiver front end 152 to demodulate and downconvert the received RF signals. The output of the combiner 210 may logically represent the analog baseband signal that may result after the processing by the receiver front end 152. The offset signal Bias may be the DC offset introduced by various components of the receiver front end 152 during processing of the received RF signal. For example, a local oscillator (not shown) used to downconvert the received RF signal to a baseband signal may introduce a DC offset if the local oscillator frequency is not the same as a carrier frequency of the received RF signal.

The processed signal, which may be an analog baseband signal, may be communicated to the ADC 212. The ADC 212 may convert the analog baseband signal to a digital baseband signal. The number of bits for each sample may depend on design considerations. An exemplary number of bits may be eight signed bits for each analog sample. Accordingly, each sample may have a value in the range of, for example, -127 to +127. Other embodiments of the invention may use other ranges, for example, from -128 to +127, or from -127 to +128. The digital baseband signal may be communicated to the CMF block 214, which may appropriate filter the digital baseband signal. The CMF block 214, which may be, for example, in the RF receiver system 150, may perform digital filtering that corresponds to digital filtering by a corresponding CMF block (not shown) in, for example, the transmitter block 110. The CMF block 214 may, for example, receive data eight bits at a time, and output data eight bits at a time.

The digitally filtered signal may be communicated to the baseband processor 216 for appropriate processing, such as, for example, offsetting of the offset signal Bias introduced by the receiver front end 152. The output of the baseband processor 216 may be, for example, a digital baseband signal Sig_Out. The receive path may have been described for a single signal for exemplary purposes. However, an embodiment of the invention may receive, for example, I and Q signals from the receiver front end 152 represented by the combiner 210. Accordingly, the ADC 212, the CMF 214, and the baseband processor 216 may process the I signal independently of the Q signal. One architecture may comprise two separate blocks or circuitry to handle the I and Q signals.

FIG. 2B is a diagram illustrating exemplary sampling of a waveform, in accordance with an embodiment of the invention. Referring to FIG. 2B, there is shown 2 graphs 250 and 260. The graph 250 may show a sinusoidal wave 252. If the sinusoidal wave 252 has a zero DC offset at DC_0, then a portion of the waveform between the time instants T1 and T4 may have positive amplitude values, and a portion of the waveform between the time instants T4 and T7 may have negative amplitude values. The time instants T1, T4, and T7 may indicate zero crossings. If the sinusoidal wave 252 has a negative DC offset at DC_1, then the portion of the waveform between the time instants T2 and T3 may have positive amplitude values, while the portions of the waveform between the time instants T1 and T2, and T3 and T7 may have negative amplitude values. The time instants T2 and T3 may indicate zero crossings. If the sinusoidal wave 252 has a positive DC offset at DC_2, then the portions of the waveform between the time instants T1 and T5, and T6 and T7 may have positive amplitude values, and a portion of the waveform between the time instants T5 and T6 may have negative amplitude values. The time instants T5 and T6 may indicate zero crossings.

The graph 260 may illustrate samples of the sinusoidal wave 252 having a zero DC offset at DC_0. The sinusoidal wave 252 may be sampled by, for example, the ADC 212. Accordingly, the samples at the sample points S1, S11, and S21, which may correspond to the zero crossings at time instants T1, T4, and T7, respectively, may have digital values of zero. The samples at the sample points S2 ... S10 may comprise positive digital values, and the samples at the sample points S12 ... S20 may comprise negative digital values. For example, if the samples at the sample points S1 ... S21 are represented by an 8-bit number, the amplitude may range from -127 to +127. Other embodiments of the invention may allow, for example, a range from -128 to +127, or from-127 to +128.

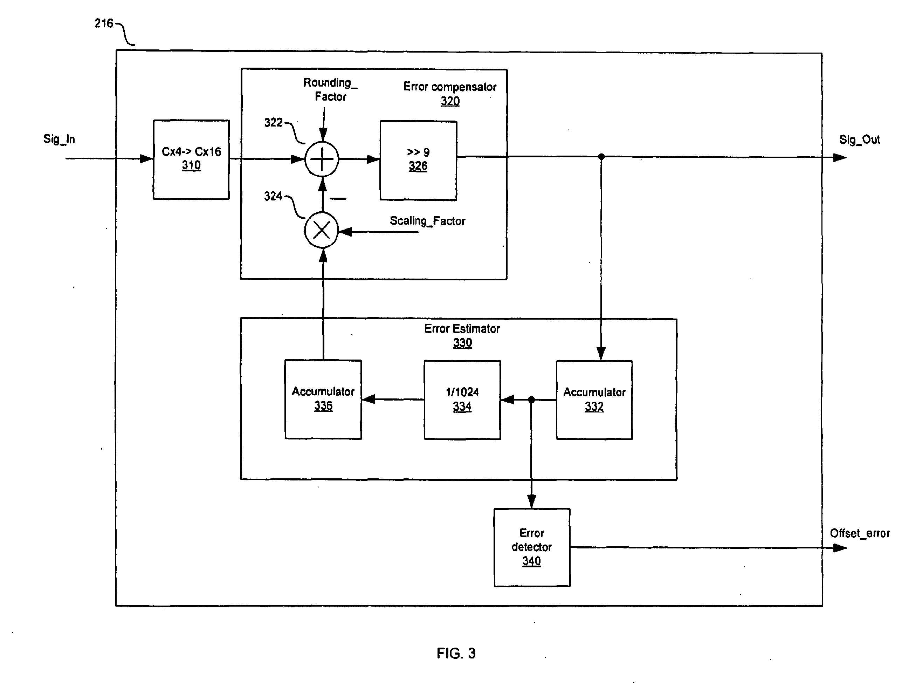

FIG. 3 is a block diagram of exemplary DC offset compensation circuitry, in accordance with an embodiment of the invention. Referring to FIG. 3, there is shown the baseband processor 216 that may comprise an interpolator block 310, an offset compensator block 320, an offset estimator block 330, and an error detector block 340. An input to the baseband processor 216 may comprise a digital signal Sig_In that may be communicated from, for example, the CMF block 214. The baseband processor 216 may comprise, for example, two outputs. The first output may be the digital baseband signal Sig_Out, which may be the digital baseband signal that is compensated for DC offset. The second output may be the digital signal Offset_Error that may comprise information on the amount of DC offset present in the digital baseband signal Sig_Out. The offset compensator block 320 may comprise a combiner block 322, a scaling block 324, and a de-scaling block 326. The offset estimator block 330 may comprise accumulator blocks 332 and 336, and a de-scaling block 334.

The interpolator block 310 may comprise suitable logic, circuitry, and/or code that may enable interpolating digital values between digital inputs. For example, the interpolator block 310 may interpolate values to generate 16 digital output values from 4 digital inputs values. This may occur, for example, by oversampling from 4 samples per CDMA chip to 16 samples per CDMA chip. Each input may be 8 bits, and each output may be 17 bits, for example. The 8-bit inputs and the interpolated 8-bit values may be shifted left 9 bits to generate the 17-bit outputs. The combiner block 322 may comprise suitable logic, circuitry, and/or code that may enable combining of a plurality of inputs. For example, the combiner block 322 may combine the digital inputs from the interpolator block 310 and the negative values from the scaling block 324, and a digital value Rounding_Factor. The digital value Rounding_Factor may have a value that may be dependent upon a design of the baseband processor 216. For example, an embodiment of the invention may assign a value of 256 to the digital value Rounding_Factor. The Rounding_Factor may be communicated to the combiner block 322 by, for example, the processor 156. Other embodiments of the invention may, for example, make the value of the Rounding_Factor constant. The combiner block 322 may receive 17-bit inputs from the interpolator block 310 and the scaling block 324, and output a 17-bit value.

The scaling block 324 may comprise suitable logic, circuitry, and/or code that may enable scaling a digital input by a value indicated by a scaling input. For example, the digital input communicated by the accumulator 336 may be scaled appropriately by the Scaling_Factor input. Since the Scaling_Factor input may indicate a value that may be a power of 2, an embodiment of the invention may implement the scaling block 324 to, for example, shift left the digital input signal by an appropriate number of bits. Accordingly, the Scaling_Factor may be a number that indicates a number of bits to shift left. The Scaling Factor may be communicated to the scaling block 324 by, for example, the processor 156. The scaling block 324 may scale an 8-bit input by the Scaling_Factor, where the Scaling_Factor may indicate an exponent as large as 9. Accordingly, the scaling block 324 may output a 17-bit value.

The de-scaling block 326 may comprise suitable logic, circuitry, and/or code that may enable dividing an input by an appropriate value. Various embodiments of the invention may implement the de-scaling block 326, for example, to shift right by an appropriate number of bits. For example, the number of bits to shift right may be 9 bits. Accordingly, the 17-bit input from the combiner block 322 may be reduced to an 8-bit output of the de-scaling block 326. The output of the de-scaling block may be the digital signal Sig_Out. The digital signal Sig_Out may be, for example, processed further by the baseband processor and/or communicated to other circuitry in the RF receiver system 150 for further processing to audio, video, and/or text for application systems, such as, for example, email.

The accumulator block 332 may comprise suitable logic, circuitry, and/or code that may enable receiving and accumulating 8-bit values of the digital signal Sig_Out. The accumulator block 332 may support signed 8-bit values. Accordingly, the total accumulated by the accumulation block 332 may increase or decrease with each 8-bit value received from the de-scaling block 326. The accumulator block 332 may accumulate N 8-bit inputs and dump the final accumulated value after the Nth input. Accordingly, the accumulator block 332 may have a value of zero after a dump of the accumulated value. The output may be communicated to the de-scaling block 334 and the error detector 340. The output of the accumulator block may be, for example, 18 bits. In an embodiment of the invention, N may be equal to, for example, 1024.

The de-scaling block 334 may comprise suitable logic, circuitry, and/or code that may enable dividing an input by an appropriate value, such as, for example, 1024. Accordingly, if the division factor is a power of two, an embodiment of the invention may implement the de-scaling block 334, for example, to shift right by an appropriate number of bits. If the dividing factor is 1024, the de-scaling block 334 may shift the input data to the right by 10 bits. Accordingly, the output of the de-scaling block 334 may be 8 bits. The 8-bit output of the de-scaling block 334 may be an approximate average of the 1024 8-bit inputs accumulated by the accumulator block 332. The output of the de-scaling block 334 may be communicated to the accumulator block 336.

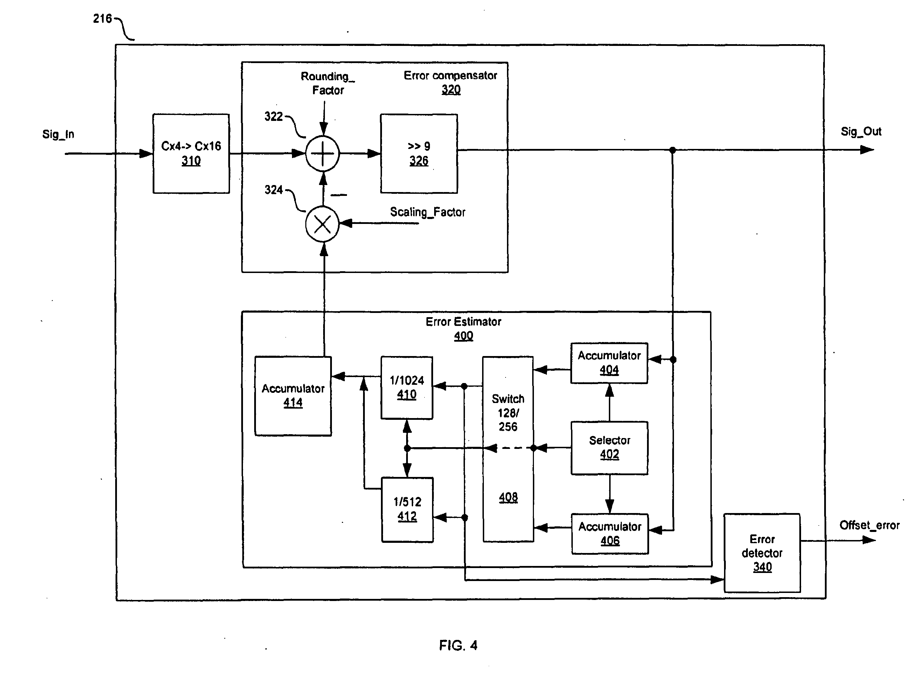

The accumulator block 336 may comprise suitable logic, circuitry, and/or code that may enable receiving of 8-bit inputs and accumulation of the 8-bit inputs without dumping. Accordingly, the accumulator block 336 may generate an output that may be a DC offset of the received signal, and the DC offset may be constantly updated. The output of the accumulator block 336 may be, for example, 8 to 11 bits wide. The error detector 340 may comprise suitable logic, circuitry, and/or code that may enable processing the output of the accumulator block 332 to generate an error signal Offset_Error. The algorithm used for generating the error signal Offset_Error may be implementation dependent. The error signal Offset_Error may be communicated to a processor, for example, the processor 156. The processor 156 may determine whether the received error signal Offset_Error may be, for example, above an error threshold level. The error threshold level may be pre-determined, or dynamically determined depending on various transmission characteristics, such as, for example, signal to noise ratio, strength of received signals, and/or bit error rate. The processor 156 may, for example, adjust reception parameters of the RF receiver system 150 based on the error signal Offset_Error. The adjustment of the reception parameters is discussed in more detail with respect to FIG. 4.

In operation, the digital data Sig_In may be received by the interpolator block 310 from, for example, the CMF 214 8 bits at a time, where each 8-bit data may represent a sample of an analog signal. The interpolator block 310 may process the digital data Sig_In to interpolate 16 bytes of data for every 4 bytes of the digital data Sig_ln. For example, this may occur due to 4x oversampling from 4 samples per CDMA chip to 16 samples per CDMA chip. The interpolator block 310 may also filter each 8-bit data to generate a 17-bit data using the 512 FIR filter gain. Accordingly, the output of the interpolator block 310 may be 17 bits wide, for example. The 17-bit output from the interpolator block 310 may be communicated to the combiner block 322. The combiner block 322 may combine, or add, the 17-bit data from the interpolator block 310 with the negative value of the 17-bit data from the scaling block 324 and with the Rounding_Factor of 256. The result may be a 17-bit value that may be communicated to the de-scaling block 326. The de-scaling block 326 may shift right the 17-bit input by 9 bits. The result may be an 8-bit data that may be rounded to the nearest decimal integer due to the addition of the Rounding_Factor value of 256 by the combiner block 322.

The 8-bit data from the de-scaling block 326 may be communicated for further processing for presentation to a user of the RF receiver system 150. The 8-bit data from the de-scaling block 326 may also be communicated to the accumulator block 332. The accumulator block 332 may accumulate, or add, for example, 1024 8-bit data and then communicate the final accumulated data to the de-scaling block 324 and the error detector block 340. Since the 8-bit data being accumulated may be signed, the accumulated data may keep track of the offset signal Bias because the non-Bias values may tend to cancel each other.

After communicating the accumulated data, the accumulator block 332 may clear the accumulated data to zero. Accordingly, each accumulated data may be dependent on the next 1024 8-bit data received after communicating the previous accumulated data. The output of the accumulator block 332 may be 18 bits wide. The error detector block 340 may generate an error signal that may be used by, for example, the baseband processor 216 and/or the processor 156, for controlling operation of the RF receive system 150.

The de-scaling block 334 may, for example, shift right the 18-bit data from the accumulator block 332 by 10 bits. The resulting 8-bit data may represent a truncated average of the 1024 8-bit data accumulated by the accumulator block 332. Accordingly, the 8-bit data from the de-scaling block 334 may be an average residual DC offset value for the received 1024 samples. The 8-bit data from the de-scaling block 334 may be communicated to the accumulator block 336. The accumulator block 336 may accumulate the 8-bit data. The accumulator block 336 may accumulate the 8-bit data from the de-scaling block 334, thereby effectively integrating the average DC offsets. Accordingly, the output of the accumulator block 336 may be used as a feedback signal to reduce the DC offset in the digital input signal Sig_In received by the interpolator block 310.

The output of the accumulator block 336 may comprise 8+(9 - P_DC_GAIN) number of bits. The output of the accumulator block 336 may be communicated to the scaling block 324. The scaling block 324 may scale the output from the accumulator block 336 by a factor of 2^P_DC_GAIN. This may be accomplished, for example, by shifting left the output from the accumulator block by P_DC_GAIN number of bits. Accordingly, the result may be a 17-bit wide data. The 17-bit wide data may be communicated to the combiner block 322.

The value of P_DC_GAIN may be a fixed value in some embodiments of the invention. In other embodiments of the invention, a processor, such as, for example, the processor 156, may communicate the P_DC_GAIN value to the accumulator 336 and to the scaling block 324. Additionally, an assumption was made that the offset signal was a DC signal for ease of explanation. However, the invention need not be limited to reduction of a DC offset signal. Non-DC offset signals may also reduced using various embodiments of the invention.

FIG. 4 is a block diagram of an exemplary multi-mode DC offset compensation circuitry, in accordance with an embodiment of the invention. Referring to FIG. 4, there is shown the baseband processor 216. The baseband processor 216 may comprise the interpolator block 310, the offset compensator block 320, the offset estimator block 400, and the error detection block 340. The interpolator block 310, the offset compensator block 320, and the error detector block 340 may be as described with respect to FIG. 3. The offset estimator block 400 may comprise a selector block 402, accumulator blocks 404, 406, and 414, a switch block 408, and de-scaling blocks 410 and 412.

The selector block 402 may comprise suitable logic, circuitry, and/or code that may enable selection of operation of either the accumulator block 404 or 406. The selector block 402 may also enable the switch to communicate an output from either the accumulator 404 or the accumulator 406 to either the de-scaling block 410 or the de-scaling block 412. The selector block 402 may also, for example, indicate to the de-scaling blocks 410 and 412 to enable operation of each block, and also whether each block may generate an output. Commands may be communicated to the selector block 402 for a specific selection and operation of the accumulators 404 and 406, and for the de-scaling blocks 410 and 412, for example, by the processor 156 or other circuitry in the baseband processor 216. The accumulator block 404 may accumulate, for example, 1024 samples while the accumulator block 406 may accumulate, for example, 512 samples. The de-scaling block 410 may de-scale by, for example, a factor of 1024 while the de-scaling block 412 may de-scale by, for example, a factor of 512.

In operation, the error signal Offset_Error from the error detector 340 may be monitored by, for example, the processor 156. The processor 156 may determine that the error signal Offset_Error may indicate that a different number of samples may be used for error correction. Accordingly the processor 156 may communicate appropriate commands to the selector block 402. The selector block 402 may then select an appropriate accumulator to accumulate data and an appropriate de-scaling block to generate an averaged error data.

For example, if the error signal Offset_Error varies relatively fast, for example, at a rate of 100 Hz, the processor 156 may determine that a smaller number of samples may be accumulated in order to provide a faster feedback. Accordingly, the processor accumulator block 406 and the de-scaling block 412 may be selected. However, if the error signal Offset_Error is relatively small, the processor 156 may determine that a larger number of samples may be accumulated. Accordingly, the processor accumulator block 404 and the de-scaling block 410 may be selected.

While an embodiment of the invention may have been described with respect to FIG. 4, the invention need not be so limited. For example, other embodiments of the invention may comprise a single configurable accumulator that may output accumulation of N number of input data. The output data may be communicated to a single de-scaling block that may de-scale by an appropriate value 2^N. Accordingly, the functionality of the multi-mode error estimator block may be implemented in various ways.

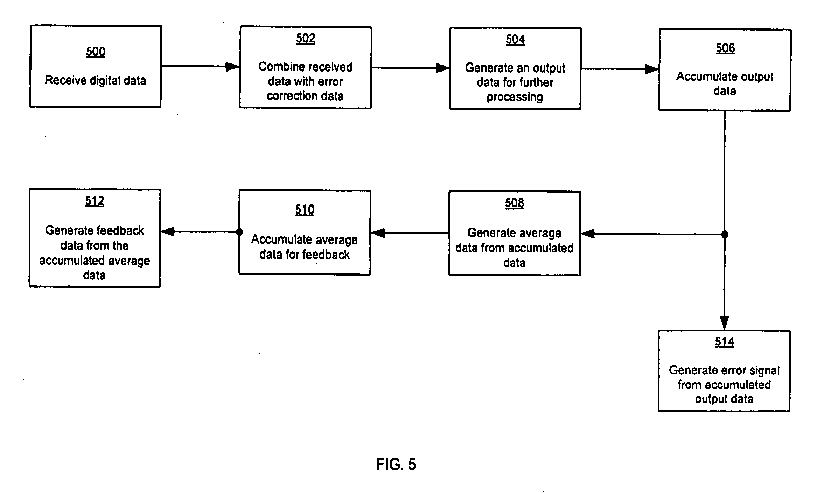

FIG. 5 is an exemplary flow chart for DC offset compensation, in accordance with an embodiment of the invention. Referring to FIG. 5, there is shown steps 500 to 514. In step 500, digital data may be received by, for example, the interpolator 310. The interpolator block 310 may process the received digital data to generate 16 8-bit data for every 4 8-bit inputs. This may occur, for example, by oversampling from 4 samples per CDMA chip to 16 samples per CDMA chip. The four 8-bit inputs may be, for example, four samples of a received WCDMA chip. Each 8-bit data may also be shifted left by 9 bits, and the resulting data may be output as 17-bit data. In step 502, the 17-bit data from the interpolator block 310 may be combined, or added, with a 17-bit feedback data, and a Rounding-Factor of 256 by the combiner block 322. The combined 17-bit data from the combiner block 322 may be communicated to the de-scaling block 326. In step 504, the de-scaling block 326 may shift right the 17-bit input to generate an 8-bit data. The 8-bit data generated by the de-scaling block 326 may be communicated as data Sig_Out to other circuitry, for example, in the baseband processor 216 or the processor 156, for further processing before being presented to a user as, for example, voice, video, and/or or text. The data from the de-scaling block 326 may also be communicated to the accumulator blocks 404 and 406.

In step 506, the accumulator block 404 and/or 406 may accumulate the data from the de-scaling block 326. The accumulator block 404 and/or 406 may accumulate an appropriate number of data. For example, the accumulator block 404 may accumulate data for 256 WCDMA chips, at four 8-bit samples per chip, and the accumulator block 406 may accumulate data for 128 WCDMA chips, at four 8-bit samples per chip. Since the output from the de-scaling block 326 may comprise sixteen 8-bit data for each WCDMA chip, the accumulator blocks 404 and 406 may accumulate one-fourth of the data communicated by the de-scaling block 326. Since the data may tend to cancel each other, the accumulated data may be considered to be accumulation of common bias, or offset.

The next step may be step 508 and step 514. In step 508, the accumulator blocks 404 and 406 may communicate the total accumulated data after the appropriate number of 8-bit data have been accumulated to the switch block 408. The switch block 408 may communicate the accumulated data from the accumulator blocks 404 and 406 to the appropriate de-scaling block 410 and 412, respectively. The de-scaling blocks 410 and 412 may right shift the received accumulated data to generate a truncated average. The truncated average may represent, for example, an average offset value for the respective number of samples accumulated by the accumulator blocks 404 or 406.

For example, the de-scaling block 410 may right shift the 18-bit data generated by the accumulator block 404 by 10 bits to generate an 8-bit data. The de-scaling block 412 may right shift the 17-bit data generated by the accumulator block 406 by 9 bits to generate an 8-bit data. The 8-bit data generated by the de-scaling blocks may be considered as, for example, an average of the offset error data received for accumulation by the accumulator blocks 404 and 406. After outputting the accumulated data, the accumulator blocks 404 and 406 may set the accumulated value to zero to start accumulation over again.

In step 510, the average offset value from the de-scaling block 410 or 412 may be communicated to the accumulator block 414. The accumulator block 414 may not dump and clear the accumulated value as the accumulator blocks 404 and 406. Rather the accumulator block 414 may constantly accumulate the average offset values. Accordingly, the accumulator block 414 may integrate the error over time to provide a feedback signal for correction of the offset in the input signal Sig_In. In step 512, the accumulator block 414 may output data to the scaling block 324. The data from the accumulator block 414 may be further scaled by the scaling block 324 to generate, for example, a 17-bit feedback data to the combiner block 322. In step 514, the error detector 340 may receive data from either the accumulator block 404 or 406, via the switch block 408. The error detector block 340 may generate an error signal that may be communicated to, for example, the processor 156. The processor 156 may determine whether to use, for example, the accumulator block 404 or 406.

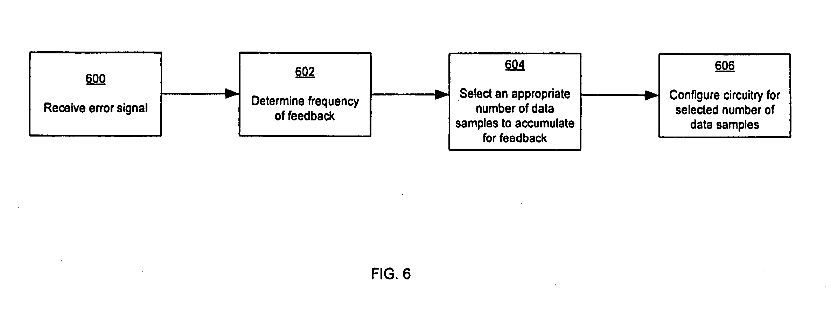

FIG. 6 is an exemplary flow chart illustrating multi-mode DC offset compensation, in accordance with an embodiment of the invention. Referring to FIG. 6, there is shown steps 600 to 606. In step 600, the processor 156, for example, may receive the error signal from the error detector 340. In step 602, the processor 156 may determine the type of feedback to use based on the error signal. For example, the processor 156 may determine that the error signal is a fast varying offset error, for example, above 100 Hz, or a slow varying offset error, for example, less than or equal to 100 Hz. In step 604, the processor 156 may determine the appropriate number of samples to accumulate for feedback correction of the offset error. For example, the processor 156 may select fewer samples to accumulate to provide a faster feedback for a fast varying offset error. If the processor 156 determines that the error signal is not a fast varying offset error, for example, 100 Hz or less, the processor 156 may select the accumulator block 404 to provide feedback using a larger number of samples, which may provide more accuracy.

In step 606, under control of the processor 156, the selector block 402 may be enabled to select specific blocks for the number of samples to be accumulated for feedback. Some embodiments of the invention may select between two different numbers of samples to accumulate, while other embodiments of the invention may allow dynamic configuration of the various blocks so as to provide an optimal number of samples to be accumulated. For example, the accumulator block 404 and/or 406 may be configured by, for example, the selector block 402 and/or the processor 156 to accumulate a specific number of samples. Similarly, the de-scaling blocks 410 and/or 412 may be configured by, for example, the selector block 402 and/or the processor 156 to de-scale by an appropriate value.

Aspects of a method and system for multimode DC offset compensation may comprise, for example, the processor 156 that selects a number of signal samples to be used for feedback signal generation. The accumulator block 404 and/or 406 may accumulate the selected number of signal samples, and the de-scaling block 410 and/or 412 may determine an average value of the accumulated signal samples. The accumulator block 414 may accumulate the average value from the accumulator block 404 and/or 406 to generate a running feedback error value. The signal samples may be, for example, samples of WCDMA signals.

The number of signal samples accumulated by the accumulator block 404 and/or 406 may be based on a signal offset error, or residual DC. For example, an embodiment of the invention may comprise two different numbers of signal samples to accumulate. A larger number of signal samples may be accumulated when the signal offset error is less than or equal to a threshold. A smaller number of signal samples may be accumulated when the signal offset error is greater than the threshold. In an embodiment of the invention, the accumulator 404 and/or 406 may accumulate a number of signal samples that may be equal to 2^{N}. Accordingly, the de-scaling block 410 and/or 412 may right shift right the total value from the accumulator block 404 and/or 406 by N bits to determine the average of the number of signal samples.

Another embodiment of the invention may provide a machine-readable storage, having stored thereon, a computer program having at least one code section executable by a machine, thereby causing the machine to perform the steps as described above for multimode DC offset compensation.

Accordingly, the present invention may be realized in hardware, software, or a combination of hardware and software. The present invention may be realized in a centralized fashion in at least one computer system, or in a distributed fashion where different elements are spread across several interconnected computer systems. Any kind of computer system or other apparatus adapted for carrying out the methods described herein is suited. A typical combination of hardware and software may be a general-purpose computer system with a computer program that, when being loaded and executed, controls the computer system such that it carries out the methods described herein.

The present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

## Claims

1. A method for processing baseband signals in a circuit, the method comprising:
receiving a baseband signal having a signal offset;
combining said received baseband signal with a feedback signal to generate a processed baseband signal having an attenuated signal offset;
selecting a number of signal samples from said processed baseband signal, said selected number of signal samples being one of at least two numbers;
accumulating said selected number of signal samples for generating a signal offset error, the signal offset error having a DC component and a sinusoidal component;
averaging said accumulated selected number of signal samples; and
accumulating said determined average to generate said feedback signal, wherein selecting said number of signal samples comprises one of selecting a smaller of said at least two numbers when said DC component is greater than a threshold and selecting said smaller of said at least two numbers when a frequency of said sinusoidal component is greater than a threshold frequency.

2. The method according to claim 1, wherein said signal samples are samples of WCDMA signals.

3. The method according to claim 1, further comprising selecting a larger of said at least two numbers when said DC component of said signal offset error is less than or equal to said threshold.

4. A machine-readable storage having stored thereon, a computer program having at least one code section for processing signals in a circuit, the at least one code section being executable by a machine for causing the machine to perform steps comprising:
receiving a baseband signal having a signal offset;
combining said received baseband signal with a feedback signal to generate a processed baseband signal having an attenuated signal offset;
selecting a number of signal samples from said processed baseband signal, said selected number of signal samples being one of at least two numbers;
accumulating said selected number of signal samples for generating a signal offset error, the signal offset error having a DC component and a sinusoidal component;
averaging said accumulated selected number of signal samples; and
accumulating said determined average to generate said feedback signal, wherein selecting said number of signal samples comprises one of selecting a smaller of said at least two numbers when said DC component is greater than a threshold and selecting said smaller of said at least two numbers when a frequency of said sinusoidal component is greater than a threshold frequency.

5. A system for processing baseband signals in a circuit, the system comprising:
at least one circuit (216) adapted to receive a baseband signal having a signal offset;
said at least one circuit (216) further adapted to combine said received baseband signal with a feedback signal to generate a processed baseband signal having an attenuated signal offset;
said at least one circuit (216) further adapted to select a number of signal samples from said processed baseband signal, said selected number of signal samples being one of at least two numbers;
said at least one circuit (216) further adapted to accumulate said selected number of signal samples for generating a signal offset error, the signal offset error having a DC component and a sinusoidal component;
said at least one circuit (216) further adapted to determine an average of said accumulated selected number of signal samples; and
said at least one circuit (216) further adapted to accumulate said determined average to generate said feedback signal, wherein selecting said number of signal samples comprises one of selecting a smaller of said at least two numbers when said DC component is greater than a threshold and selecting said smaller of said at least two numbers when a frequency of said sinusoidal component is greater than a threshold frequency.

6. The system according to claim 5, wherein said signal samples are samples of WCDMA signals.

## Patentansprüche

1. Verfahren zum Verarbeiten von Basisbandsignalen in einer Schaltung, wobei das Verfahren umfasst:
Empfangen eines Basisbandsignals mit einem Signal-Offset;
Kombinieren des empfangenen Basisbandsignals mit einem Rückkopplungssignal, um ein verarbeitetes Basisbandsignal mit einem abgeschwächten Signal-Offset zu erzeugen;
Auswählen einer Anzahl von Signalabtastungen aus dem verarbeiteten Basisbandsignal, wobei die ausgewählte Anzahl von Signalabtastungen eine von wenigstens zwei Anzahlen ist;
Akkumulieren der ausgewählten Anzahl von Signalabtastungen, um einen Signal-Offset-Fehler zu erzeugen, wobei der Signal-Offset-Fehler eine Gleichstromkomponente und eine Sinuskomponente aufweist;
Mitteln der akkumulierten ausgewählten Anzahl von Signalabtastungen; und
Akkumulieren des bestimmten Mittelwerts, um das Rückkopplungssignal zu erzeugen, wobei das Auswählen der Anzahl von Signalabtastungen eines des Auswählens einer kleineren der wenigstens zwei Anzahlen umfasst, wenn die Gleichstromkomponente größer ist, als ein Schwellenwert, und des Auswählens der kleineren der wenigstens zwei Anzahlen, wenn eine Frequenz der Sinuskomponente größer ist, als eine Schwellenfrequenz.

2. Verfahren nach Anspruch 1, wobei die Signalabtastungen Abtastungen von WCDMA-Signalen sind.

3. Verfahren nach Anspruch 1, das des Weiteren das Auswählen einer größeren der wenigstens zwei Anzahlen umfasst, wenn die Gleichstromkomponente des Signal-Offset-Fehlers kleiner oder gleich dem Schwellenwert ist.

4. Maschinenlesbarer Speicher, auf dem ein Computerprogramm gespeichert ist, das wenigstens einen Codeabschnitt aufweist zum Verarbeiten von Signalen in einer Schaltung, wobei der wenigstens eine Codeabschnitt von einer Maschine ausgeführt werden kann, um zu veranlassen, dass die Maschine Schritte durchführt, die umfassen:
Empfangen eines Basisbandsignals mit einem Signal-Offset;
Kombinieren des empfangenen Basisbandsignals mit einem Rückkopplungssignal, um ein verarbeitetes Basisbandsignal mit einem abgeschwächten Signal-Offset zu erzeugen;
Auswählen einer Anzahl von Signalabtastungen aus dem verarbeiteten Basisbandsignal, wobei die ausgewählte Anzahl von Signalabtastungen eine von wenigstens zwei Anzahlen ist;
Akkumulieren der ausgewählten Anzahl von Signalabtastungen, um einen Signal-Offset-Fehler zu erzeugen, wobei der Signal-Offset-Fehler eine Gleichstromkomponente und eine Sinuskomponente aufweist;
Mitteln der akkumulierten ausgewählten Anzahl von Signalabtastungen; und
Akkumulieren des bestimmten Mittelwerts, um das Rückkopplungssignal zu erzeugen, wobei das Auswählen der Anzahl von Signalabtastungen eines des Auswählens einer kleineren der wenigstens zwei Anzahlen umfasst, wenn die Gleichstromkomponente größer ist, als ein Schwellenwert, und des Auswählens der kleineren der wenigstens zwei Anzahlen, wenn eine Frequenz der Sinuskomponente größer ist, als eine Schwellenfrequenz.

5. System zum Verarbeiten von Basisbandsignalen in einer Schaltung, wobei das System aufweist:
wenigstens eine Schaltung (216), die so ausgelegt ist, dass sie ein Basisband empfängt, das einen Signal-Offset aufweist;
wobei die wenigstens eine Schaltung (216) des Weiteren so ausgelegt ist, dass sie das empfangene Basisbandsignal mit einem Rückkopplungssignal kombiniert, um ein verarbeitetes Basisbandsignal zu erzeugen, das einen abgeschwächten Signal-Offset aufweist;
wobei die wenigstens eine Schaltung (216) des Weiteren so ausgelegt ist, dass sie eine Anzahl von Signalabtastungen aus dem verarbeiteten Basisbandsignal auswählt, wobei die ausgewählte Anzahl von Signalabtastungen eine von wenigstens zwei Anzahlen ist;
wobei die wenigstens eine Schaltung (216) des Weiteren so ausgelegt ist, dass sie die ausgewählte Anzahl von Signalabtastungen akkumuliert, um einen Signal-Offset-Fehler zu erzeugen, wobei der Signal-Offset-Fehler eine Gleichstromkomponente und eine Sinuskomponente aufweist;
wobei die wenigstens eine Schaltung (216) des Weiteren so ausgelegt ist, dass sie einen Mittelwert der akkumulierten ausgewählten Anzahl von Signalabtastungen bestimmt; und
wobei die wenigstens eine Schaltung (216) des Weiteren so ausgelegt ist, dass sie den bestimmten Mittelwert akkumuliert, um das Rückkopplungssignal zu erzeugen, wobei das Auswählen der Anzahl von Signalabtastungen eines des Auswählens einer kleineren der wenigstens zwei Anzahlen umfasst, wenn die Gleichstromkomponente größer ist, als ein Schwellenwert, und des Auswählens der kleineren der wenigstens zwei Anzahlen, wenn eine Frequenz der Sinuskomponente größer ist, als eine Schwellenfrequenz.

6. System nach Anspruch 5, wobei die Signalabtastungen Abtastungen von WCDMA-Signalen sind.

## Revendications

1. Procédé de traitement de signaux en bande de base dans un circuit, le procédé comprenant les étapes suivantes :
réception d'un signal en bande de base présentant un décalage de signal ;
combinaison dudit signal en bande de base reçu avec un signal de réaction pour générer un signal en bande de base traité présentant un décalage de signal atténué ;
sélection d'un nombre d'échantillons de signal à partir dudit signal en bande de base traité, ledit nombre sélectionné d'échantillons de signal étant un d'au moins deux nombres ;
accumulation dudit nombre sélectionné d'échantillons de signal pour générer une erreur de décalage de signal, l'erreur de décalage de signal ayant une composante CC et une composante sinusoïdale ;
moyennage dudit nombre sélectionné accumulé d'échantillons de signal ; et
accumulation de ladite moyenne déterminée pour générer ledit signal de réaction, la sélection dudit nombre d'échantillons de signal comprenant la sélection d'un plus petit desdits au moins deux nombres lorsque ladite composante CC est supérieure à un seuil et/ou la sélection dudit plus petit desdits au moins deux nombres lorsqu'une fréquence de ladite composante sinusoïdale est supérieure à une fréquence de seuil.

2. Procédé selon la revendication 1, dans lequel lesdits échantillons de signal sont des échantillons de signaux WCDMA.

3. Procédé selon la revendication 1, comprenant en outre une étape de sélection d'un plus grand desdits au moins deux nombres lorsque ladite composante CC de ladite erreur de décalage de signal est inférieure ou égale audit seuil.

4. Mémoire lisible par machine dans laquelle est stocké un programme informatique ayant au moins une section de codage pour traiter les signaux dans un circuit, ladite au moins une section de codage étant exécutable par une machine afin que la machine puisse effectuer les étapes suivantes :
réception d'un signal en bande de base présentant un décalage de signal ;
combinaison dudit signal en bande de base reçu avec un signal de réaction pour générer un signal en bande de base traité ayant un décalage de signal atténué ;
sélection d'un nombre d'échantillons de signal à partir dudit signal en bande de base traité, ledit nombre sélectionné d'échantillons de signal étant un d'au moins deux nombres ;
accumulation dudit nombre sélectionné d'échantillons de signal pour générer une erreur de décalage de signal, l'erreur de décalage de signal ayant une composante CC et une composante sinusoïdale ;
moyennage dudit nombre sélectionné accumulé d'échantillons de signal ; et
accumulation de ladite moyenne déterminée pour générer ledit signal de réaction, la sélection dudit nombre d'échantillons de signal comprenant une sélection d'un plus petit desdits au moins deux nombres lorsque ladite composante CC est supérieure à un seuil et/ou la sélection dudit plus petit desdits au moins deux nombres lorsqu'une fréquence de ladite composante sinusoïdale est supérieure à une fréquence de seuil.

5. Système de traitement de signaux en bande de base dans un circuit, le système comprenant :
au moins un circuit (216) adapté pour recevoir un signal en bande de base présentant un décalage de signal ;
ledit au moins un circuit (216) étant en outre adapté pour combiner ledit signal en bande de base avec un signal de réaction pour générer un signal en bande de base traité présentant un décalage de signal atténué ;
ledit au moins un circuit (216) étant en outre adapté pour sélectionner un nombre d'échantillons de signal à partir dudit signal en bande de base traité, ledit nombre sélectionné d'échantillons de signal étant un d'au moins deux nombres ;
ledit au moins un circuit (216) étant en outre adapté pour accumuler ledit nombre sélectionné d'échantillons de signal pour générer une erreur de décalage de signal, l'erreur de décalage de signal ayant une composante CC et une composante sinusoïdale ;
ledit au moins un circuit (216) étant en outre adapté pour déterminer une moyenne dudit nombre sélectionné accumulé d'échantillons de signal ; et
ledit au moins un circuit (216) étant en outre adapté pour accumuler ladite moyenne déterminée pour générer ledit signal de réaction, la sélection dudit nombre d'échantillons de signal comprenant la sélection d'un plus petit desdits au moins deux nombres lorsque ladite composante CC est supérieure à un seuil et/ou la sélection dudit plus petit desdits au moins deux nombres lorsqu'une fréquence de ladite composante sinusoïdale est supérieure à une fréquence de seuil.

6. Système selon la revendication 5, dans lequel lesdits échantillons de signal sont des échantillons de signaux WCDMA.
